# EUROPEAN PATENT APPLICATION

(11) **EP 4 481 497 A1**
(43) Date of publication of application: **25.12.2024**
(21) Application number: 23756133.7
(22) Date of filing: 27.01.2023
(51) Int. Cl.: G03F 7/20, H01L 21/683

(54) **HOLDING APPARATUS, LITHOGRAPHY APPARATUS, AND METHOD FOR MANUFACTURING ARTICLE**

(30) Priority: 18.02.2022 JP 2022024019
(71) Applicant: CANON KABUSHIKI KAISHA, Tokyo 146-8501 (JP)
(72) Inventor: IMOTO, Kohei, Tokyo 146-8501 (JP)
(74) Representative: Canon Europe Limited
(86) International application number: PCT/JP2023/002561
(87) International publication number: WO 2023/157605

(57) **Abstract**

A holding apparatus includes a holding unit configured to hold an object, a phase change material arranged in the holding unit or on a holding surface for the object, which undergoes phase change between an amorphous phase and a crystalline phase and changes in volume with the phase change, and a control unit configured to control heating of the phase change material using a heating unit configured to heat the phase change material so as to deform the holding surface by causing volume change of the phase change material.

## Description

### TECHNICAL FIELD

The present invention relates to a holding apparatus, a lithography apparatus, and an article manufacturing method.

### BACKGROUND ART

In a semiconductor manufacturing process, the undesirable unevenness or distortion of the surface of a semiconductor substrate (to be simply referred to as "substrate" hereinafter) affects processing accuracy during processing the substrate. To prevent this, it has been proposed to provide a mechanism for deforming the substrate in a substrate holding mechanism for holding the substrate, thereby correcting the unevenness or distortion of the substrate.

PTL 1 describes that a plurality of height control elements whose heights can be changed are arranged on a stage where a substrate is placed, and the unevenness of the substrate is controlled by driving the height control elements. As the height control elements used for nanometer-order position control, for example, piezoelectric elements are used.

However, for the piezoelectric element, it is sometimes difficult to control the position of a piezoelectric actuator even for a short time. In general, a piezoelectric actuator has hysteretic drive characteristics and displacement creep change characteristics. Therefore, in order to achieve highly accurate and stable driving, it is necessary to separately provide a sensor that measures the displacement of the piezoelectric actuator and perform position control in a closed servo loop. In general, it is difficult to perform position control of a piezoelectric actuator in an open loop.

To solve the problem with the piezoelectric actuator as described above, PTL 2 proposes an application of an electrostatic actuator that can stably maintain the position owing to low charge leakage.

### CITATION LIST

### PATENT LITERATURE

PTL 1: Japanese Patent Laid-Open No. 2013-026233
PTL 2: Japanese Patent Laid-Open No. 2013-135218

### SUMMARY OF INVENTION

### TECHNICAL PROBLEM

However, due to miniaturization of a semiconductor device or the like, the accuracy required for substrate deformation is becoming more severe, and the actuator that deforms the substrate is required to have high stability and accuracy. Even with the electrostatic actuator described in PTL 2, the charge leakage cannot be reduced to zero. Thus, a substrate deformation mechanism with a highly stable actuator applied thereto is demanded.

The present invention provides a technique that enables highly accurate and stable control of the shape of a substrate.

### SOLUTION TO PROBLEM

According to one aspect of the present invention, there is provided a holding apparatus characterized by comprising a holding unit configured to hold an object, a phase change material arranged in the holding unit or on a holding surface for the object, which undergoes phase change between an amorphous phase and a crystalline phase and changes in volume with the phase change, and a control unit configured to control heating of the phase change material using a heating unit configured to heat the phase change material so as to deform the holding surface by causing volume change of the phase change material.

### ADVANTAGEOUS EFFECTS OF INVENTION

According to the present invention, a technique that enables highly accurate and stable control of the shape of a substrate can be provided.

Other features and advantages of the present invention will be apparent from the following description taken in conjunction with the accompanying drawings. Note that the same reference numerals denote the same or like components throughout the accompanying drawings.

### BRIEF DESCRIPTION OF DRAWINGS

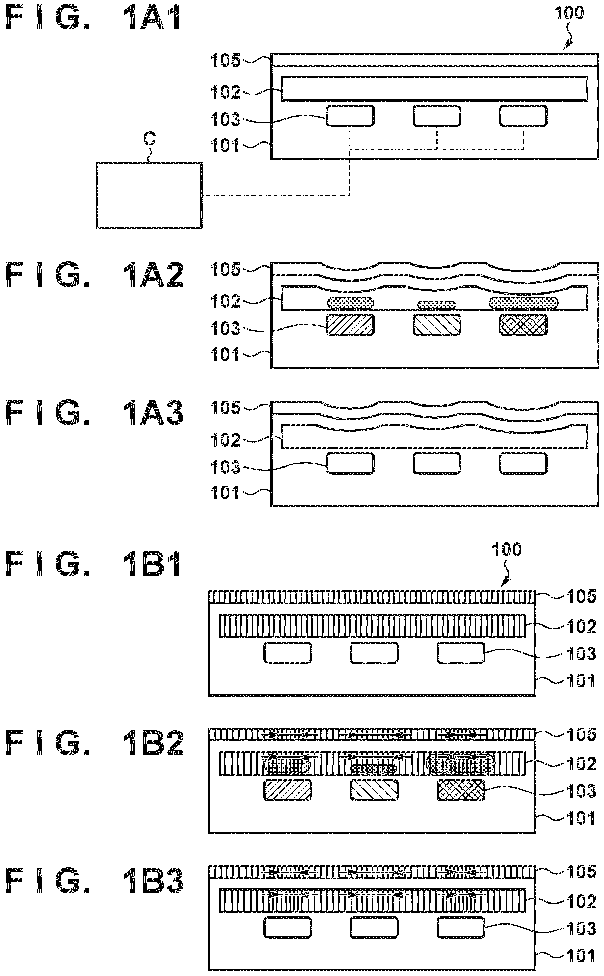

Fig. 1A1 is a view for explaining the arrangement of a holding apparatus and a substrate deformation process in Example 1;
Fig. 1A2 is a view for explaining the arrangement of the holding apparatus and the substrate deformation process in Example 1;
Fig. 1A3 is a view for explaining the arrangement of the holding apparatus and the substrate deformation process in Example 1;
Fig. 1B 1 is a view for explaining the arrangement of the holding apparatus and the substrate deformation process in Example 1;
Fig. 1B2 is a view for explaining the arrangement of the holding apparatus and the substrate deformation process in Example 1;
Fig. 1B3 is a view for explaining the arrangement of the holding apparatus and the substrate deformation process in Example 1;
Fig. 2A1 is a view for explaining the arrangement of the holding apparatus and the substrate deformation process in Example 2;

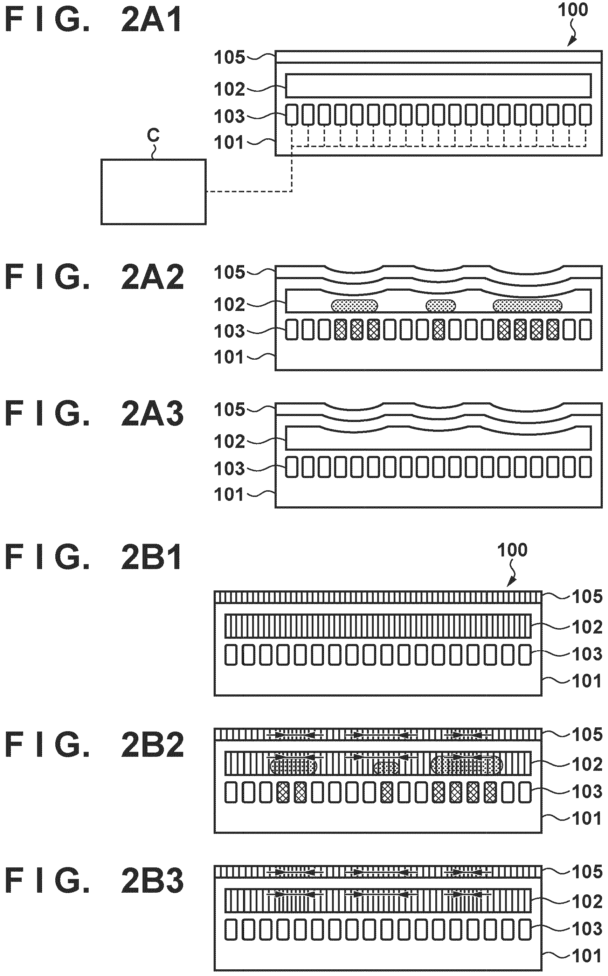

Fig. 2A2 is a view for explaining the arrangement of the holding apparatus and the substrate deformation process in Example 2;
Fig. 2A3 is a view for explaining the arrangement of the holding apparatus and the substrate deformation process in Example 2;
Fig. 2B 1 is a view for explaining the arrangement of the holding apparatus and the substrate deformation process in Example 2;
Fig. 2B2 is a view for explaining the arrangement of the holding apparatus and the substrate deformation process in Example 2;
Fig. 2B3 is a view for explaining the arrangement of the holding apparatus and the substrate deformation process in Example 2;

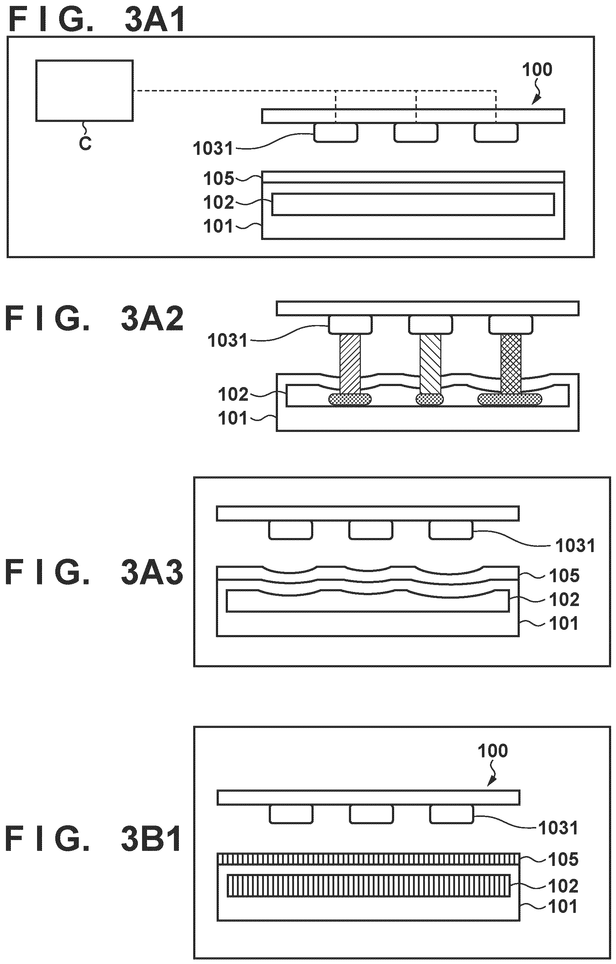

Fig. 3A1 is a view for explaining the arrangement of the holding apparatus and the substrate deformation process in Example 3;
Fig. 3A2 is a view for explaining the arrangement of the holding apparatus and the substrate deformation process in Example 3;
Fig. 3A3 is a view for explaining the arrangement of the holding apparatus and the substrate deformation process in Example 3;

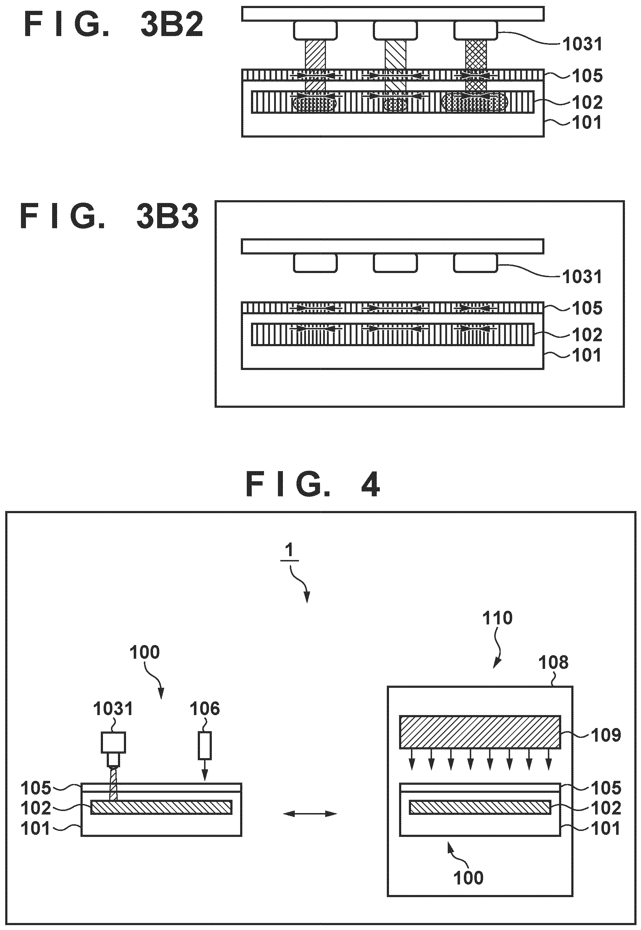

Fig. 3B 1 is a view for explaining the arrangement of the holding apparatus and the substrate deformation process in Example 3;
Fig. 3B2 is a view for explaining the arrangement of the holding apparatus and the substrate deformation process in Example 3;
Fig. 3B3 is a view for explaining the arrangement of the holding apparatus and the substrate deformation process in Example 3;
Fig. 4 is a view showing the configuration of a substrate processing system in Example 3;

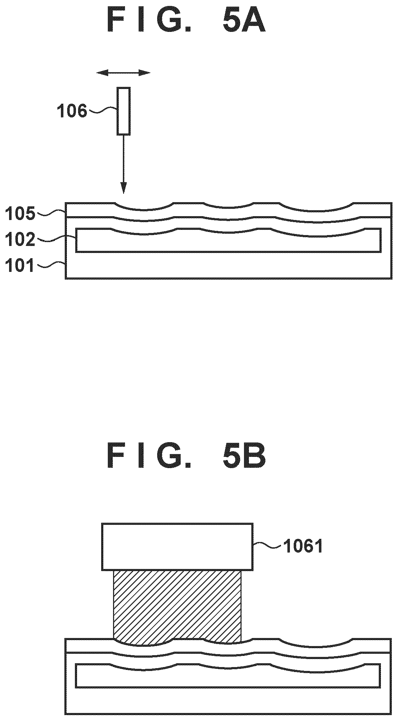

Fig. 5A is a view for explaining a method of measuring the displacement of a substrate;
Fig. 5B is a view for explaining a method of measuring the displacement of the substrate;

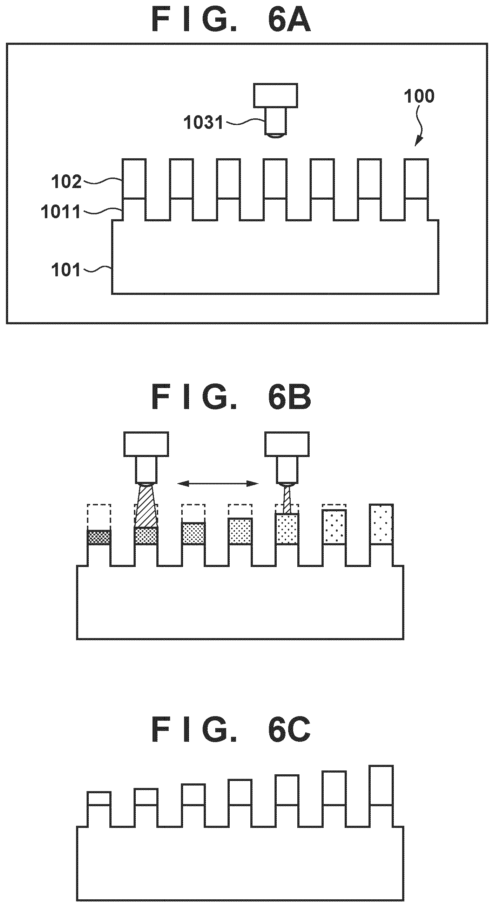

Fig. 6A is a view for explaining the arrangement of a holding apparatus and a substrate deformation process in Example 4;
Fig. 6B is a view for explaining the arrangement of the holding apparatus and the substrate deformation process in Example 4;
Fig. 6C is a view for explaining the arrangement of the holding apparatus and the substrate deformation process in Example 4;

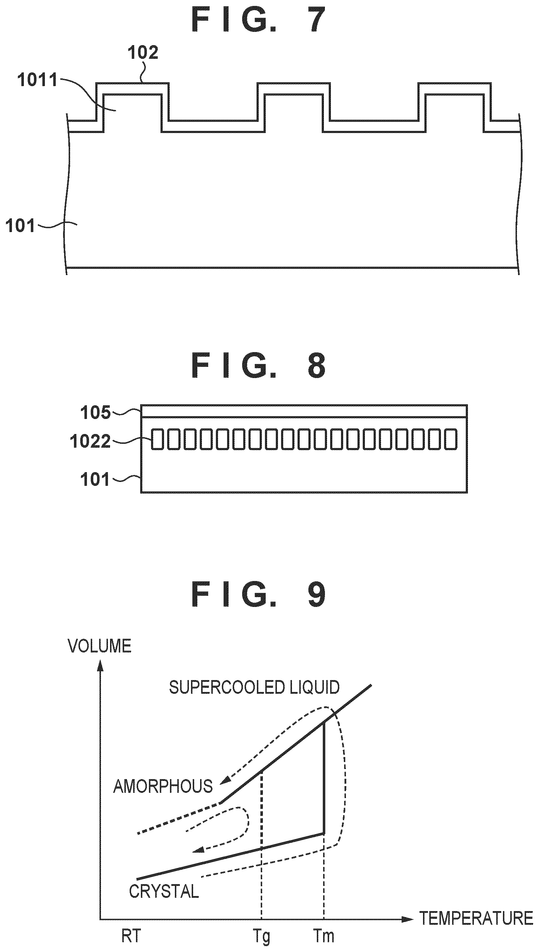

Fig. 7 is a view exemplarily showing the arrangement of a phase change material in Example 4;
Fig. 8 is a view exemplarily showing the arrangement of the phase change material in Example 5;
Fig. 9 is a graph showing the characteristics of the phase change material;

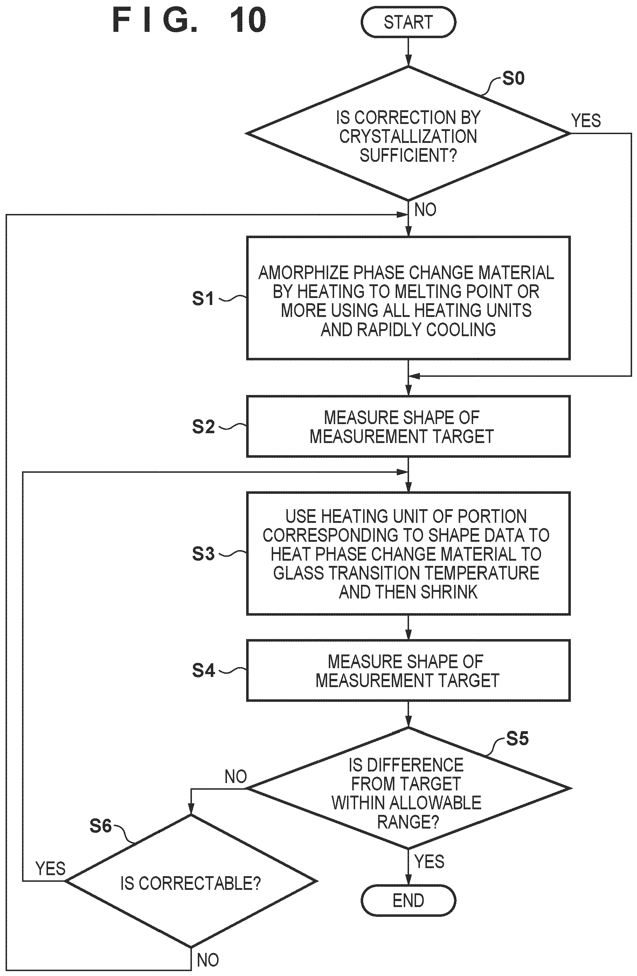

Fig. 10 is a flowchart illustrating the substrate deformation process;

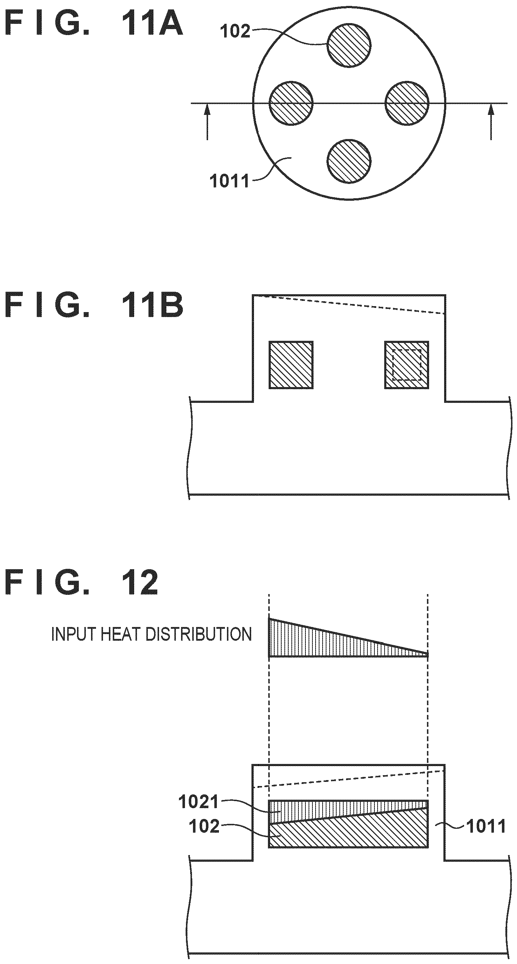

Fig. 11A is a view for explaining a method of tilting the upper surface of a projecting portion in Example 6;
Fig. 11B is a view for explaining the method of tilting the upper surface of the projecting portion in Example 6;
Fig. 12 is a view for explaining another method of tilting the upper surface of the projecting portion in Example 6;

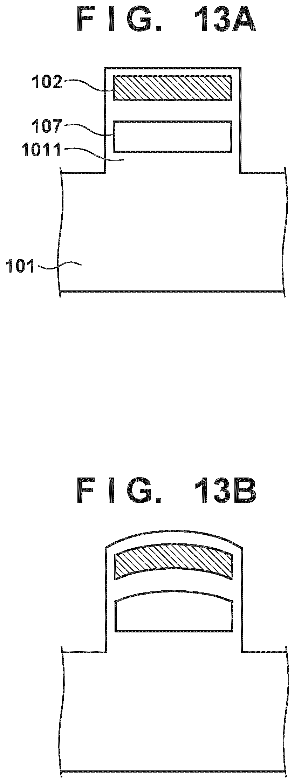

Fig. 13A is a view showing the arrangement for increasing the amount of upward deformation of the phase change material in Example 7;
Fig. 13B is a view showing the arrangement for increasing the amount of upward deformation of the phase change material in Example 7; and

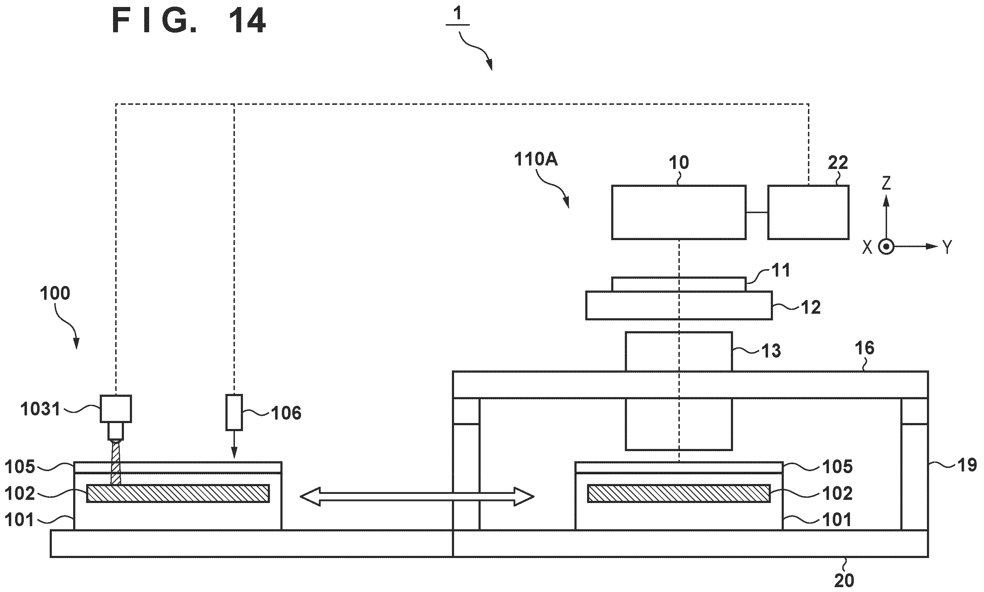

Fig. 14 is a view showing the arrangement of an exposure apparatus which utilizes a holding apparatus.

### DESCRIPTION OF EMBODIMENTS

The accompanying drawings, which are incorporated in and constitute a part of the specification, illustrate embodiments of the invention and, together with the description, serve to explain principles of the invention.

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

### <First Embodiment>

Fig. 1A1 shows an example of the arrangement of a holding apparatus 100 that holds a plate as an object to be held according to the first embodiment. In an example, the plate is a semiconductor wafer used in a lithography apparatus. In this case, the holding apparatus 100 is a substrate holding apparatus. Alternatively, the plate is an original (mask or reticle) with a pattern drawn thereon, which is used in an exposure apparatus as a kind of the lithography apparatus. In this case, the holding apparatus 100 is an original holding apparatus. Alternatively, the plate is a mold with a pattern formed thereon, which is used in an imprint apparatus as a kind of the lithography apparatus. In this case, the holding apparatus 100 is a mold holding apparatus. In the following description, as an example, the plate is assumed to be a substrate 105 (semiconductor wafer) used in a substrate processing apparatus such as the lithography apparatus.

The holding apparatus 100 includes a substrate holding unit 101 that chucks and holds the substrate 105 as the plate. As the chucking method of the substrate 105 by the substrate holding unit 101, a vacuum method of holding the substrate 105 by generating a negative pressure between the substrate 105 and the substrate holding surface (holding surface) of the substrate holding unit 101 can be used. Alternatively, as the chucking method of the substrate 105 by the substrate holding unit 101, an electrostatic attraction method of holding the substrate 105 using an electrostatic attraction force, or the like can also be used.

The holding apparatus 100 further includes a phase change material 102 and a control unit C that controls heat input to the phase change material 102. The control unit C controls heating of the phase change material 102 using a heating unit, which heats the phase change material 102, so as to deform the holding surface by causing volume change of the phase change material 102. In this embodiment, a heating unit 103 is arranged in the substrate holding unit 101. In Fig. 1A1, the phase change material 102 is arranged in the substrate holding unit 101, but it may be arranged on the substrate holding surface (the upper surface of the substrate holding unit 101).

In this embodiment, the heating unit 103 includes a plurality of heating units. Each heating unit 103 can include a heater element made of a resistive heat generating material for heating the phase change material 102. As the resistive heat generating material, for example, a mixture of one or more of copper, a nickel alloy, a chromium alloy, and the like can be used. The heater element generates heat by power supplied from a power supply (not shown). Alternatively, each of the plurality of heating units 103 can include an induction heating element that performs heating using electromagnetic induction generated by a coil arranged around a ferromagnetic material. In Fig. 1A1, the plurality of heating units 103 are arranged below the phase change material 102, but they may be arranged in the phase change material 102, or between the phase change material 102 and the substrate holding surface of the substrate holding unit 101. Variations regarding the arrangement of the phase change material 102 and the plurality of heating units 103 will be described later.

With reference to Fig. 9, the phase change material 102 will be described. The phase change material 102 is a material that undergoes phase change between a non-crystalline phase (amorphous phase) and a crystalline phase and changes in volume with the phase change. Fig. 9 is a graph showing the transition of the crystalline structure and the characteristics of the volume of the phase change material with temperature. When the phase change material is heated from a room temperature RT to a melting point Tm and rapidly cooled, the phase change material becomes a supercooled liquid and has an amorphous structure with a large volume in a room temperature state. On the other hand, when the phase change material is heated from the room temperature RT to a temperature exceeding a glass transition temperature Tg and then slowly cooled, the phase change material has a crystalline structure with a small volume in the room temperature state. That is, by changing the heating and cooling methods, the structure in the room temperature state can be changed. As shown in Fig. 9, the crystal structure in which elements are aligned tends to have a small volume, and the amorphous structure with random elements tends to have a large volume.

The phase change material has been put to practical use in the field of rewritable recording media. For example, a chalcogenide-based phase change material Ge-Sb-Te (to be referred to as GST hereinafter) is widely used as the recording layer of a rewritable optical disc such as a DVD or a Blu-ray^{®} disc and as the recording material of a nonvolatile memory. The volume of the GST changes by about 5% between the amorphous phase and the crystalline phase. The control unit C utilizes this characteristic to cause volume change of the phase change material 102, thereby controlling the plurality of heating units 103 so as to deform the holding surface of the holding unit 101.

### (Example 1)

A specific example of the method of deforming a substrate in the holding apparatus 100 will be described below. First, with reference to Figs. 1A1-A3 and Fig. 10, Example 1 according to the first embodiment will be described.

In step S0, the control unit C determines whether the target shape can be achieved by the shape correction amount caused by volumetric shrinkage due to crystallization of the phase change material 102 at present, that is, whether the correction by crystallization is sufficient. If it is determined that the correction by crystallization is not sufficient, the process advances to amorphization processing in step S1. If it is determined that the correction by crystallization is sufficient, the process skips step S1 and advances to shape measurement in step S2.

In step S1, the control unit C drives (supplies power to) all of the plurality of heating units 103 to heat the phase change material 102 to a temperature exceeding the melting point Tm, and then instantaneously stops the heating to rapidly cool the phase change material 102. The rapid cooling may be performed by instantaneously stopping the power supply to the plurality of heating units 103. Alternatively, forced cooling by heat exchange further using a refrigerant may be employed. Due to the rapid cooling, the phase change material 102 becomes the amorphous phase, and has the largest volume (first processing). In this case, since the phase change material 102 is heated to the melting point or more, it is better to receive as little external force as possible. Therefore, during heating, it is preferable to temporarily retreat the substrate 105 from the substrate holding unit 101.

In step S2, the control unit C measures the shape of a measurement target by using a measurement unit as will be described later. The shape of interest here is the unevenness of the surface of the substrate, that is, the deformation amount of the surface of the substrate in the out-of-plane direction. Accordingly, the measurement result includes information of the deformation amount of the surface of the substrate in the out-of-plane direction. The measurement target may be the surface of the substrate 105 held by the substrate holding unit 101 as shown in Figs. 5A and 5B, or may be the surface (substrate holding surface) of the substrate holding unit 101 if the substrate 105 is retreated. However, considering the distortion caused by the substrate holding unit 101 holding the substrate 105 and the unevenness measurement error, error factors can be further reduced when the substrate 105 held by the substrate holding unit 101 is set as the measurement target. In the following description of Example 1, the surface of the substrate 105 held by the substrate holding unit 101 is set as the measurement target. Instead of the substrate 105, a measurement substrate may be used.

As the measurement method, either a method using a displacement measurement unit 106 that measures a local displacement as shown in Fig. 5A or a method using a plane displacement measurement unit 1061 that collectively measures the unevenness in a wide range as shown in Fig. 5B may be employed. The sensor used in Fig. 5A can be a ranging interferometer, a trigonometric displacement meter, or the like. By driving (relatively driving) one or both of the displacement measurement unit 106 and the substrate holding unit 101 in the lateral and depth directions of the drawing surface, the height at an arbitrary position in the substrate holding unit 101 or the substrate 105 is measured. In the collective measurement method shown in Fig. 5B, for example, a plane interferometer is used as the plane displacement measurement unit 1061. However, since the plane interferometer with a measurement range that can measure the entire surface of the substrate 105 leads to an increase in cost, the plane displacement measurement unit with a measurement range smaller than the substrate 105 as shown in Fig. 5B may be used. In this case, as in Fig. 5A, by relatively driving the plane displacement measurement unit 1061 and the substrate holding unit 101, the entire surface of the substrate 105 can be measured.

In general, the method of relatively driving the displacement measurement unit 106 and the substrate holding unit 101 as shown in Fig. 5A is affected by the stage running error of the displacement measurement unit 106 and/or the substrate holding unit 101. Therefore, in order to improve measurement accuracy, the plane displacement measurement unit which collectively measures a wide range can decrease the measurement error more.

It is preferable that the size of the collective measurement range of the plane displacement measurement unit 1061 includes a shot region as the maximum constituent unit of the device manufactured in the substrate 105. In this case, it is possible to collectively measure the shot region, and the error caused by relative driving can be decreased. In addition, by setting the collective measurement range slightly larger than the shot region and performing stitching to match the overlap of displacement measurement with the adjacent shot region, the measurement can be extended to the entire surface of the substrate 105.

In step S3, as shown in Fig. 1A2, based on the measurement result of the shape of the substrate holding surface or the surface of the substrate 105 measured in step S2, the control unit C decides some heating units (specific one or more heating units) to perform heating among the plurality of heating units 103. In accordance with the position and amount to lower the substrate holding unit 101, the control unit C supplies power to some heating units decided above among the plurality of heating units 103. With this, the phase change material 102 is partially heated. More specifically, in a portion of the substrate surface desired to be largely recessed, the control unit C adjusts to raise the temperatures of the specific heating units or increase the amount of heat input thereto such that the wide range of the phase change material 102 exceeds the glass transition temperature Tg. Thereafter, by slowly cooling, the phase change material 102 in the range exceeding the glass transition temperature Tg changes to the crystalline phase and shrinks in volume (second processing). The slow cooling can be performed by, for example, gradually decreasing the power supply amount (heat input amount) to the heated heating unit. As a result, as shown in Fig. 1A3, the surface holding surface of the substrate holding unit 101 can be recessed. By changing the range that changes to the crystalline phase and shrinks by the heating state of the heating unit, the unevenness of the substrate holding surface can be controlled.

As an example, a case will be described where a phase change material whose volume changes by 10% upon phase change is used in the phase change material 102. In Fig. 1A2, the temperature is raised at the position of the rightmost heating unit among the plurality of heating units 103 such that the entire phase change material 102 exceeds the glass transition temperature Tg, and then slow cooling is performed. In this case, the volume of the phase change material 102 shrinks by 10%. As an example, when the thickness dimension of the phase change material 102 is 10 µm, the dimension in the thickness direction shrinks by 0.01 µm due to a volume change of 10%.

The GST has been taken as an example of the phase change material 102, but it is also possible to use a Ge-Te, Ge-Sb-Te, Ge-In-Sb-Te, or Ag-In-Sb-Te based material. All of them are materials that show a volume change of several % due to phase change, and an optimal phase change material can be designed and selected based on the relationship among the substrate holding unit 101, the plurality of heating units 103, and the like.

In step S4, as in step S2, the control unit C measures the shape of the substrate 105 serving as the measurement target. Then, in step S5, the control unit C determines whether the difference between the shape of the substrate 105 and the target shape falls within an allowable range. If the difference does not fall within the allowable range, the process returns to step S3, and the control unit C executes heating and cooling again to modify the shape. However, as the modification from step S5 to step S3 is repeated, the entire phase change material 102 crystallizes, and the volume cannot be further reduced. Therefore, in step S6, the control unit C determines whether the phase change material 102 is in a deformation correctable range. If the phase change material 102 is not in the deformation correctable range, the process returns to step S 1, and the control unit C resets the phase change material 102, that is, heats the phase change material 102 again to the melting point or more and rapidly cools it to make it amorphous.

The method of controlling the unevenness (that is, the shape in the out-of-plane direction) of the substrate 105 has been described above. With reference to Figs. 1B1-B3, a case will be described below where, when deforming the substrate 105 according to Example 1, the shape of the substrate 105 in the in-plane direction is controlled. As in the above description, the flowchart of Fig. 10 can also be applied to this case.

A deformation in the in-plane direction is generally called a distortion. The substrate 105 shown in Fig. 1B1 is expressed in a vertical grid pattern to conveniently explain the state of distortion, and the distribution of distortion after deformation is expressed by the density of vertical grid in Figs. 1B2 and 1B3.

As in the case of the substrate unevenness deformation described above, in step S1, the control unit C drives all of the plurality of heating units 103 to heat the phase change material 102 to the melting point Tm or more, and then instantaneously stops the heating to rapidly cool the phase change material 102. Due to the rapid cooling, the phase change material 102 becomes the amorphous phase, and has the largest volume. In this case, since the phase change material 102 is heated to the melting point or more, it is better to receive as little external force as possible. Therefore, during heating, it is preferable to temporarily retreat the substrate 105 from the substrate holding unit 101.

In step S2, in the state in which the substrate 105 is held by the substrate holding unit 101, the control unit C measures the distortion of the substrate 105. The state in which the substrate 105 is held by the substrate holding unit 101 is set to transmit the distortion of the deformed substrate holding unit 101 to the substrate 105 in next step S3. The distortion of the substrate 105 is measured by, for example, measuring the pattern arranged in the surface of the substrate 105. Accordingly, in this example, the measurement result includes information of the deformation amount of the surface of the substrate in the in-plane direction.

Next, the deformation processing of the substrate 105 in step S3 will be described. In the state in which the substrate 105 is held by the substrate holding unit 101, as shown in Fig. 1B2, the control unit C supplies power to some (specific one or more heating units) of the plurality of heating units 103 based on the shape data obtained by the measurement in step S2. With this, the phase change material 102 is locally heated, and the substrate holding unit 101 and the substrate 105 chucked and held thereby can be distorted. The distortion amount given to the substrate 105 may be derived based on the shape data measured in step S2, or may be derived by adding the distortion amount inherent in the substrate 105 measured in advance to the shape data obtained by the measurement in step S2. Alternatively, the amount of distortion caused by substrate processing by the substrate processing apparatus utilizing the holding apparatus 100 may be obtained in advance, and the distortion amount given to the substrate 105 may be derived so that the distortion caused by the substrate processing is reduced.

During heating and deformation of the phase change material 102 in step S3, as shown in Fig. 1B2, in the state in which the substrate 105 is chucked and held by the substrate holding unit 101, power supply to each of the plurality of heating units 103 is controlled to locally heat the phase change material 102. At this time, in a portion where the substrate 105 is desired to be distorted so as to have a large shrinkage amount, the control unit C adjusts to raise the temperature of the heating unit or increase the amount of heat input thereto such that the wide range of the phase change material 102 exceeds the glass transition temperature Tg. Thereafter, by slowly cooling, the phase change material 102 in the range exceeding the glass transition temperature Tg changes to the crystalline phase and shrinks in volume. As a result, the local shrinkage of the substrate holding unit 101 is transmitted to the substrate 105, and the substrate 105 can also be distorted. By changing the range that changes to the crystalline phase and shrinks by the heating state of the heating unit, the distortion of the substrate 105 can be controlled.

Thereafter, as in the case of the substrate unevenness control in Figs. 1A1 to 1A3, the control unit C measures the distortion of the substrate 105 in step S4, and determines in step S5 whether the difference between the distortion amount of the substrate 105 and the target distortion amount falls within the allowable range. In step S6, the control unit C determines whether the phase change material 102 is in a deformation correctable range, and repeats processing in accordance with the determination results in step S5 and step S6.

### (Example 2)

In Example 1 shown in Figs. 1A1 to 1B3, the configuration to control the deformation of the substrate or the holding surface by the temperatures or heat amounts of some of the plurality of heating units 103 has been described. To the contrary, in Example 2, as shown in Figs. 2A1-A3, the plurality of heating units 103 include more heating units than in Example 1, and the heating units located near the portion desired to be deformed and corresponding to the desired deformation amount are driven on and off.

As in Example 1, the flowchart of Fig. 10 can also be applied to the control procedure in Example 2. Also in Fig. 2A2, as in Fig. 1A2 in Example 1, the heating unit near the portion of the substrate 105 desired to be recessed among the plurality of heating units 103 is turned on, thereby controlling the shrinkage of the phase change material 102. As a result, as shown in Fig. 2A3, the substrate holding surface of the substrate holding unit 101 can be recessed.

The difference between Example 1 and Example 2 will be described. In Example 1, the amount of heat input to each of the plurality of heating units 103 is controlled in a plurality of gradations. To the contrary, in Example 2, each of the plurality of heating units 103 is ON/OFF-controlled, and heating of the phase change material 102 is controlled by the arrangement density of the heating units to be turned on. In Fig. 2A2, the arrangement density of the heating units to be turned on is high in the portion desired to be largely recessed in step S3, and the arrangement density of the heating units 103 to be turned on is low in the portion to be slightly recessed. To control the temperature rise portion by turning on/off the plurality of heating units 103, it is desirable that the plurality of heating units 103 are arranged finer than the short-period wavelength of the periodic component in the substrate plane in the target shape or target distortion of the substrate 105.

Figs. 2B1 to 2B3 show the deformation processing focusing on the in-plane direction. The contents of this processing are similar to those shown Figs. 1B1 to 1B3 described above, so that a description will be omitted.

Note that, in Example 2, in addition to selecting the heating units to rise the temperature among the plurality of heating units 103, as in Example 1, the temperatures or heat amounts of the respective heating units may be simultaneously changed to control the phase change of the phase change material 102.

### (Example 3)

In Example 3, the phase change material 102 is heated from outside the substrate holding unit 101. Fig. 3A1 shows an arrangement example according to Example 3. In Fig. 3A1, the phase change material 102 is arranged in the substrate holding unit 101, but a plurality of heating units 1031 are arranged upwardly apart from the substrate holding surface of the substrate holding unit 101 with the substrate 105 in between. In order to perform local heating from a separated position, each of the plurality of heating units 1031 can be configured to, for example, irradiate the substrate holding surface with electromagnetic radiation such as a laser. However, if the substrate holding unit 101 and the plurality of heating units 1031 can be arranged close to each other, the plurality of heating units 1031 may include electromagnetic induction heating or heaters. Each of the plurality of heating units 1031 may be configured to emit electromagnetic radiation which is transmitted through the substrate 105. In an example, when the substrate is a silicon wafer, the plurality of heating units 1031 can be configured to emit infrared rays which are transmitted through silicon. With this, the substrate holding unit 101 can simultaneously perform the measurement in step S2 and the substrate deformation in step S3 while holding the substrate 105 (or measurement substrate), and this can decrease the error caused by substrate replacement.

As in Example 1 and Example 2, the flowchart of Fig. 10 can also be applied to the control procedure in Example 3. With reference to Figs. 3A1 to 3A3, the processing of deforming the unevenness of the surface of the substrate 105 will be described. In step S1, the control unit C uses the plurality of heating units 1031 to heat and rapidly cool the phase change material 102, thereby bringing the phase change material 102 to the amorphous phase. In step S2, the control unit C measures the unevenness of the surface of the substrate 105 or the substrate holding surface of the substrate holding unit serving as the measurement target. Thereafter, in step S3, the control unit C heats, to the temperature equivalent to the glass transition temperature Tg, the heating unit corresponding to the portion of the phase change material 102 desired to be recessed among the plurality of heating units 1031, and slowly cools it to shrink the phase change material 102. The control unit C measures the shape of the measurement target in step S4, and determines in step S5 whether the difference between the deformation amount of the substrate 105 and the target deformation amount falls within the allowable range. In step S6, the control unit C determines whether the phase change material 102 is in a deformable range, and repeats processing in accordance with the determination results in step S5 and step S6.

Next, with reference to Figs. 3B1 to 3B3, the method of controlling the shape of the substrate 105 in the in-plane direction will be described.

In step S1, the control unit C drives all of the plurality of heating units 1031 to heat the phase change material 102 to a temperature exceeding the melting point Tm, and then rapidly cools the phase change material 102. Due to the rapid cooling, the phase change material 102 becomes the amorphous phase, and has the largest volume. In this case, since the phase change material 102 is heated to the melting point or more, it is better to receive as little external force as possible. Therefore, during heating, it is preferable to temporarily retreat the substrate 105 from the substrate holding unit 101.

In step S2, in the state in which the substrate 105 is held by the substrate holding unit 101, the control unit C measures the distortion of the substrate 105. The state in which the substrate 105 is held by the substrate holding unit 101 is set to transmit the distortion of the deformed substrate holding unit 101 to the substrate 105 in next step S3. The distortion of the substrate 105 is measured by, for example, measuring the pattern arranged in the surface of the substrate 105.

Then, in step S3, in the state in which the substrate 105 is chucked and held by the substrate holding unit 101, as shown in Fig. 3B2, the control unit C supplies power to specific one or more heating units among the plurality of heating units 1031 based on the shape data obtained by the measurement in step S2. With this, the phase change material 102 is locally heated. Thereafter, by performing slow cooling, the phase change material 102 is deformed, so that the substrate holding unit 101 and the substrate 105 chucked and held thereby can be distorted. As has been described above, in this case, each of the plurality of heating units 1031 is electromagnetic radiation which is transmitted through the substrate 105 or a measurement substrate.

As in Figs. 1B1 to 1B3 described above, the phase change material 102 in the range exceeding the glass transition temperature Tg changes to the crystalline phase and shrinks in volume. As a result, the local shrinkage of the substrate holding unit 101 is transmitted to the substrate 105, and the substrate 105 is also be distorted.

In Figs. 3A1 to 3A3 and Figs. 3B1 to 3B3, as in Example 1, the heating unit 1031 is formed by the plurality of heating units, but the heating unit 1031 may include one heating unit. In this case, the heating position of the phase change material 102 may be changed by changing the relative position between the heating unit 1031 and the substrate holding unit 101. By driving one or both of the heating unit 1031 and the substrate holding unit 101 in the lateral and depth directions of the drawing surface of Figs. 3A1 to 3A3 and Figs. 3B1 to 3B3, the relative position between the heating unit 1031 and the substrate holding unit 101 can be changed. With this, the heating position of the phase change material 102 can be changed. In a case where the heating unit 1031 is configured to emit electromagnetic radiation such as a laser beam, the heating position of the phase change material 102 can be driven to an arbitrary position by using a deflection device such as a galvano scanner. That is, the heating unit 103 can include a galvano scanner that deflects the electromagnetic radiation generated from a radiation source such that one or more portions of the phase change material 102 are irradiated with the electromagnetic radiation.

In the heating unit 1031, heat input to the phase change material 102 may be controlled by a drawing device that partially blocks or attenuates wide light that collectively heats a wide range. As the drawing device in this case, a liquid crystal shutter, a MEMS micromirror drive element, or the like is suitable.

Fig. 4 shows a configuration example of a substrate processing system 1 including the holding apparatus 100 and a substrate processing apparatus 110 which utilizes the holding apparatus 100. The holding apparatus 100 includes the substrate holding unit 101 and the phase change material 102. The substrate processing apparatus 110 includes a processing unit 108 that processes the substrate 105 held by the holding apparatus 100. The processing unit 108 includes a substrate processing mechanism 109 for substrate processing. In this embodiment, the heating unit 1031 and the displacement measurement unit 106 are arranged outside the substrate processing apparatus 110. Note that the heating unit 1031 may include the single heating unit or the plurality of heating units, as has been described above. From the viewpoint of productivity of the substrate processing apparatus 110, the measurement processing in each of steps S2 and S4 and the heating processing in each of steps S1 and S3 are desirably executed in parallel with the substrate processing at the position in the substrate processing apparatus 110 (the position below the substrate processing mechanism 109) where the substrate processing is executed. However, due to arrangement constraints of the substrate processing mechanism 109 and the like, there are cases where the displacement measurement unit 106 and the heating unit 1031 cannot be arranged in the processing unit 108. Therefore, in Fig. 4, the holding apparatus 100 is arranged at a position outside the substrate processing apparatus 110, and the deformation processing of the substrate holding surface using the heating unit 1031 and the displacement measurement unit 106 is executed there. After the deformation processing is completed and the substrate is held, the substrate holding unit 101 of the holding apparatus 100 is loaded together with the substrate 105 to the substrate processing apparatus 110 by a conveyance mechanism (not shown). In this manner, from the viewpoint of productivity, the holding apparatus 100 is preferably located in the substrate processing apparatus 110, but due to arrangement constraints of the substrate processing mechanism 109 and the like, as has been described above, the holding apparatus 100 can be provided outside the substrate processing apparatus 110. By providing the holding apparatus 100 outside the substrate processing apparatus 100, constraints on the dimensions of units of the holding apparatus 100 are mitigated. Accordingly, for example, it is also possible to form a deformation measurement unit with higher accuracy.

### <Second Embodiment>

With reference to Figs. 6A to 6C, the substrate deformation method by a holding apparatus 100 in the second embodiment will be described as Example 4.

### (Example 4)

In Fig. 6A, a substrate holding unit 101 of the holding apparatus 100 includes a plurality of convex projecting portions 1011 that support a substrate. In a substrate processing apparatus, when the substrate holding unit 101 holds a substrate, fine particles are trapped between the substrate and the substrate holding unit 101, causing local deformation of the substrate surface. As a countermeasure against this problem, the plurality of projecting portions 1011 are employed. By contacting the substrate only at the vertices of the plurality of projecting portions 1011, the contact area with the substrate is decreased, and the effect of reducing the probability of trapping particles is obtained.

A phase change material 102 is arranged on the upper surfaces of the plurality of proj ecting portions 1011. In Fig. 6A, the phase change material 102 is arranged only on the upper surfaces of the plurality of projecting portions 1011. However, as shown in Fig. 7, the phase change material 102 may be arranged not only on the plurality of projecting portions 101 but also on the surface of the substrate holding unit 101. The arrangement of the phase change material 102 as shown in Fig. 7 can be implemented by, for example, depositing the phase change material 102 on the substrate holding unit 101 by a deposition method such as spattering. In this example, the arrangement mode of the phase change material 102 on the plurality of projecting portions 1011 may be either of that shown in Fig. 6A or that shown in Fig. 7, and is appropriately designed in consideration of the employed processing method and the like.

Further, a protection layer (not shown) for protecting the phase change material 102 may be coated on the upper surface of the phase change material 102. In this case, the protection layer is desirably made of a material that transmits electromagnetic radiation from a heating unit 1031.

The operation leading to unevenness deformation of a substrate 105 in Example 4 can be controlled in accordance with the flowchart shown in Fig. 10.

By relatively driving the heating unit 1031 and the substrate holding unit 101 in the lateral and depth directions of the drawing surface, the phase change material 102 on the plurality of projecting portions 1011 is heated. Alternatively, the phase change material 102 on the plurality of projecting portions 1011 may be heated using a deflection device such as a galvano scanner. Alternatively, as in Example 3, a liquid crystal shutter, a MEMS micromirror drive element, or the like may be used to control heat input to the phase change material 102.

The control procedure of the holding apparatus 100 in Example 4 is similar to that in Example 3. First, in step S1, the phase change material 102 is made amorphous, and the shape is measured in step S2. In the measurement in step S2, as in Example 1, the measurement target may be the surface of the substrate 105 held by the substrate holding unit 101, or may be the upper surfaces of the plurality of projecting portions 1011 in the state in which the substrate 105 is not held by the substrate holding unit 101.

As the measurement method, either a method using a displacement measurement unit 106 that measures a local displacement as shown in Fig. 5A or a method using a plane displacement measurement unit 1061 that collectively measures the unevenness in a wide range as shown in Fig. 5B may be employed. As described in Example 1, in order to improve measurement accuracy, measurement using the plane displacement measurement unit that collectively measures a wide range is more preferable because it can decrease the measurement error.

In step S3, based on the shape measurement result in step S2, the phase change material 102 in the portion desired to be recessed is heated to a temperature equivalent to a glass transition temperature Tg by using the heating unit 1031, and made to shrink (Fig. 6B). Then, the shape of the measurement target is measured in step S4, and processing from step S3 to step S6 is repeated until it is determined in step S5 that the difference between the measured shape and the target shape falls within an allowable range. Fig. 6C shows an example of the controlled state of the phase change material 102 when the difference between the measured shape and the target shape falls within the allowable range.

Note that, also in this example, as shown in Fig. 4, the configuration may be employed in which heating of the phase change material 102 using the heating unit 1031 and measurement of the shape of the phase change material 102 using the displacement measurement unit are performed outside the substrate processing apparatus.

### (Example 5)

Fig. 8 shows an example of the arrangement mode of a phase change material in Example 5. In Fig. 8, a plurality of phase change materials 1022 are arranged in the substrate holding unit 101. The plurality of phase change materials 1022 may be understood as, for example, the phase change material 102 shown in Fig. 1A1 divided into a plurality of portions. By dividing the phase change material into the plurality of portions, one or more phase change materials alone, of the plurality of phase change materials 1022, arranged in the portion where unevenness or distortion is desired to be generated can be heated in a pinpoint manner. With this, controllability of in-plane deformation of the substrate 105 in the holding apparatus 100 can be improved. Further, the temperature distribution is continuous in the phase change material 102 shown in Fig. 1A1, whereas in the case of the plurality of phase change materials 1022, the temperature change is divided stepwise among them. Accordingly, it is possible to generate steep unevenness changes and distortion changes in the in-plane direction of the substrate. Furthermore, separation walls may be arranged to reduce heat transfer between adjacent phase change materials in the plurality of phase change materials 1022. Such separation walls can divide the temperature change between the adjacent phase change materials.

### (Example 6)

The phase change material 102 arranged on each of the plurality of projecting portions 1011 shown in Fig. 6A concerning Example 4 described above can further be divided into a plurality of regions. Fig. 11A is a plan view of one of the plurality of projecting portions 1011 in the substrate holding unit 101 when viewed from the substrate side, and Fig. 11B is a side view of the projecting portion 1011 shown in Fig. 11A. As shown in Fig. 11A, a plurality of (for example, four) phase change materials 102 are arranged in one projecting portion. As an example, in step S3, if only the phase change material 102 on the right side in Fig. 11B is driven (heat-input), only the phase change material 102 on the right side shrinks in volume as indicated by a dashed line. In this manner, the upper surface of the proj ecting portion 1011 can be tilted by differentiating the amount of heat input to each of the plurality of phase change materials in the projecting portion. Note that, in Fig. 11A, four phase change materials 102 are arranged in one projecting portion as an example, but the number of the phase change materials arranged therein is not limited to the particular number. However, in order to tilt the upper surface of the projecting portion at an arbitrary angle, it is desirable to arrange at least three phase change materials in one projecting portion.

With reference to Fig. 12, another method of tilting the upper surface of the projecting portion will be described. In Fig. 12, the single phase change material 102 is arranged in each of the plurality of projecting portions 1011. Here, a distribution of the amount of heat input to the phase change material 102 can be provided. For example, in step S3, if a distribution is given such that the amount of heat input is higher on the left side of the phase change material 102 in Fig. 12, the shrinkage amount of the phase change material 102 increases toward the left side of a phase change region 1021. Accordingly, the upper surface of the projecting portion 1011 can be tilted downward to the left.

### (Example 7)

With reference to Figs. 13A and 13B, an example of relatively increasing the deformation amount of the projecting portion 1011 will be described.

In Example 4 (Figs. 6A to 6C) described above, the phase change material 102 is arranged on the upper end face of the projecting portion 1011, and deformation of the substrate holding surface is implemented by the volume change due to the phase change of the phase change material 102. However, the volume change amount of the phase change material 102 is limited. Therefore, in order to increase the amount of upward deformation of the phase change material 102, as shown in Fig. 13A, a projecting portion gap 107 is provided near the lower portion of the phase change material 102 arranged in the projecting portion 1011. The expansion coefficient of the phase change material 102 due to phase change is larger than the thermal expansion coefficient of the projecting portion gap 107. Hence, when the phase change material 102 becomes amorphous and expands, as shown in Fig. 13B, like bimetal deformation, the end portion of the phase change material 102 bends toward the projecting portion gap 107 side, and the central portion of the phase change material 102 bulges upward accordingly. Thus, the amount of upward deformation of the phase change material 102 can be increased.

### <Third Embodiment>

In a substrate processing system 1 shown in Fig. 4, a substrate processing apparatus 110 which utilizes a holding apparatus 100 can be any of lithography apparatuses (an exposure apparatus, an imprint apparatus, a charged-particle beam drawing apparatus, and the like). The exposure apparatus is an apparatus that exposes, via an original, a photoresist supplied onto a substrate, thereby forming a latent image corresponding to the pattern of the original on the photoresist. The imprint apparatus is an apparatus that forms a pattern on a substrate by curing the imprint material supplied onto the substrate while a mold (original) is in contact with the imprint material. The charged-particle beam drawing apparatus is an apparatus that forms a latent image on a photoresist supplied onto a substrate by drawing a pattern on the photoresist with a charged-particle beam.

Alternatively, the substrate processing apparatus 110 may be any of a deposition apparatus (CVD apparatus or the like), a processing apparatus (laser processing apparatus or the like), and an inspection apparatus (overlay inspection apparatus or the like). Alternatively, the substrate processing apparatus 110 may be a coating/developing apparatus (coater/developer) that performs processing of coating a substrate with a resist material (adherence material) as preprocessing for a lithography process and also performs developing processing as postprocessing for the lithography process.

In order to provide a specific example, an example in which the substrate processing apparatus 110 is formed as an exposure apparatus will be described below. Fig. 14 shows the arrangement of an exposure apparatus 110A which utilizes the holding apparatus 100. As also shown in Fig. 4, the holding apparatus 100 can be installed outside the exposure apparatus 110A. In the holding apparatus 100, deformation processing of the substrate holding surface using a heating unit 1031 and a displacement measurement unit 106 is executed. Note that, as has been described above, the heating unit 1031 may include a single heating unit or a plurality of heating units. After the deformation processing is completed and the substrate is held, a substrate holding unit 101 of the holding apparatus 100 is loaded to the exposure apparatus 110A together with a substrate 105.

The exposure apparatus 110A is an exposure apparatus that exposes each of a plurality of shot regions of a substrate, for example, a step-and-scan scanning exposure apparatus that performs scanning exposure of a substrate by slit light. The exposure apparatus 110A includes an illumination optical system 10, a mask stage 12, a projection optical system 13, and a control apparatus 22. Here, the loaded substrate holding unit 101 functions as a substrate stage that moves in X and Y directions. The control apparatus 22 is formed by, for example a computer apparatus including a CPU and a memory, and comprehensively controls the exposure apparatus 110A. That is, the control apparatus 22 controls a process of transferring, to the substrate 105, the pattern formed on a mask 11 as an original (a process of performing scanning exposure of the substrate 105). Here, the function of the control unit C described above is implemented by the control apparatus 22.

The illumination optical system 10 shapes, by a light shielding member such as a masking blade included therein, light emitted from a light source (not shown) into, for example, band-like or arcuate slit light long in the X direction, and illuminates a portion of the mask 11 with this slit light. The mask 11 and the substrate 105 are held by the mask stage 12 and the substrate holding unit 101 (substrate stage), respectively, and arranged at almost optically conjugate positions (on the object plane and image plane of the projection optical system 13) via the projection optical system 13. The projection optical system 13 projects the pattern of the mask 11 to each of a plurality of shot regions of the substrate 105 held by the substrate holding unit 101. More specifically, the projection optical system 13 has a predetermined projection magnification (for example, 1/2 or 1/4), and projects the pattern formed on the mask 11 onto the substrate by the slit light. The mask stage 12 and the substrate holding unit 101 are configured to be movable in a direction (for example, Y direction) orthogonal to the optical axis direction (Z direction) of the projection optical system 13, and relatively scanned at a velocity ratio corresponding to the projection magnification of the projection optical system 13 in synchronism with each other. This enables scanning of the irradiation region in the Y direction on the substrate, and transferring the pattern formed on the mask 11 to a shot region on the substrate. Then, by sequentially repeating such scanning exposure for each of the plurality of shot regions on the substrate while moving the substrate holding unit 101, the exposure process for the one substrate 105 can be completed.

The contents of the deformation processing of the substrate holding surface of the holding apparatus 100 are as described in the first embodiment and the second embodiment. The deformation processing is preferably executed at the timing of replacing the substrate 105 or the timing when exposure to the substrate 105 is stopped during various calibrations of the apparatus.

### <Embodiment of Article Manufacturing Method>

The article manufacturing method according to the embodiment of the present invention is suitable for manufacturing an article, for example, a microdevice such as a semiconductor device or an element having a fine structure. The article manufacturing method according to this embodiment includes a step of transferring a pattern of an original to a substrate using the above-described lithography apparatus (an exposure apparatus, an imprint apparatus, a drawing apparatus, or the like), and a step of processing the substrate to which the pattern is transferred in the preceding step. The manufacturing method further includes other known steps (oxidation, deposition, vapor deposition, doping, planarization, etching, resist removal, dicing, bonding, packaging, and the like). The article manufacturing method according to this embodiment is advantageous in at least one of the performance, quality, productivity, and production cost of the article, as compared to conventional methods.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2022-024019 filed February 18, 2022, which is hereby incorporated by reference herein.

## Claims

1. A holding apparatus **characterized by** comprising:
a holding unit configured to hold an object;
a phase change material arranged in the holding unit or on a holding surface for the object, which undergoes phase change between an amorphous phase and a crystalline phase and changes in volume with the phase change; and
a control unit configured to control heating of the phase change material using a heating unit configured to heat the phase change material so as to deform the holding surface by causing volume change of the phase change material.

2. The holding apparatus according to claim 1, **characterized in that**
the control unit deforms the holding surface by executing
a first step of making the phase change material amorphous by heating the phase change material to a temperature exceeding a melting point by using the heating unit and then cooling the phase change material;
a second step of partially shrinking a volume of the phase change material by, after the first step, heating a part of the phase change material by using the heating unit to a temperature exceeding a glass transition temperature and then cooling the phase change material.

3. The holding apparatus according to claim 2, **characterized in that**
the control unit decides the part based on a measurement result of a shape of one of the holding surface and a surface of the object held by the holding unit.

4. The holding apparatus according to claim 3, **characterized in that**
the measurement result includes information of a deformation amount, in an out-of-plane direction, of the surface of the object held by the holding unit.

5. The holding apparatus according to claim 3, **characterized in that**
the measurement result includes information of a deformation amount, in an in-plane direction, of the surface of the object held by the holding unit.

6. The holding apparatus according to any one of claims 3 to 5, **characterized by** further comprising
a measurement unit configured to measure the shape of one of the holding surface and the surface of the object held by the holding unit.

7. The holding apparatus according to claim 6, **characterized in that**
the second step includes, after executing partial shrinkage of the phase change material, measuring the shape of one of the holding surface and the surface of the object held by the holding unit by using the measurement unit, and
the control unit repeats the second step until a difference between a target shape and the measured shape falls within an allowable range.

8. The holding apparatus according to any one of claims 1 to 7, **characterized in that**
the heating unit includes a plurality of heating units, and
the control unit controls an amount of heat input to each of the plurality of heating units in a plurality of gradations.

9. The holding apparatus according to any one of claims 1 to 7, **characterized in that**
the heating unit includes a plurality of heating units, and
the control unit ON/OFF-controls each of the plurality of heating units.

10. The holding apparatus according to claim 8 or 9, **characterized in that**
the plurality of heating units are arranged in the holding unit.

11. The holding apparatus according to claim 10, **characterized in that**
each of the plurality of heating units includes a heater element made of a resistive heat generating material which generates heat by supplied power.

12. The holding apparatus according to claim 10, **characterized in that**
each of the plurality of heating units includes an induction heating element that performs heating using electromagnetic induction generated by a coil arranged around a ferromagnetic material.

13. The holding apparatus according to any one of claims 1 to 9, **characterized in that**
the heating unit is arranged upwardly apart from the holding surface.

14. The holding apparatus according to claim 13, **characterized in that**
the heating unit heats the phase change material by irradiating the holding surface with electromagnetic radiation.

15. The holding apparatus according to claim 13 or 14, **characterized in that**
the holding surface includes a plurality of projecting portions, and the phase change material is arranged on an upper surface of each of the plurality of projecting portions.

16. The holding apparatus according to any one of claims 13 to 15, **characterized in that**
the heating unit includes a galvano scanner configured to deflect electromagnetic radiation generated from a radiation source such that not less than one portion of the phase change material is irradiated with the electromagnetic radiation.

17. The holding apparatus according to any one of claims 1 to 16, **characterized in that**
a plurality of the phase change materials are arranged in the holding unit.

18. The holding apparatus according to claim 17, **characterized by** further comprising
a separation wall arranged between adjacent phase change materials and configured to reduce heat transfer between the phase change materials.

19. The holding apparatus according to claim 13 or 14, **characterized in that**
the holding surface includes a plurality of projecting portions, and a plurality of phase change materials are arranged in each of the plurality of projecting portions, and
the control unit tilts an upper surface of a projecting portion by differentiating an amount of heat input to each of the plurality of phase change materials in the projecting portion.

20. The holding apparatus according to claim 13 or 14, **characterized in that**
the holding surface includes a plurality of projecting portions, and a single phase change material is arranged in each of the plurality of projecting portions, and
the control unit tilts an upper surface of a projecting portion by providing a distribution of the amount of heat input to the phase change material in the projecting portion.

21. The holding apparatus according to claim 13 or 14, **characterized in that**
the holding surface includes a plurality of projecting portions, a phase change material is arranged in each of the plurality of projecting portions, and a gap is arranged near a lower portion of the phase change material to increase a deformation amount of the phase change material.

22. A lithography apparatus that forms a pattern on a substrate, **characterized by** comprising
a holding apparatus defined in any one of claims 1 to 21, and configured to hold the substrate as an object.

23. An article manufacturing method **characterized by** comprising:
a step of forming a pattern on a substrate using a lithography apparatus defined in claim 22; and
a step of processing the substrate with the pattern formed thereon in the preceding step,
wherein an article is manufactured from the processed substrate.
